# EUROPÄISCHE PATENTSCHRIFT

(11) **EP 0 655 835 B1**
(45) Veröffentlichungstag und Bekanntmachung des Hinweises auf die Patenterteilung: **01.04.1998**
(21) Anmeldenummer: 94113500.6
(22) Anmeldetag: 30.08.1994
(51) Int. Cl.: H03K 7/08, H02P 7/29

(54) **Verfahren und Vorrichtung zur Steuerung elektrischer Geräte mittels einer Pulsweitenmodulation-Einrichtung**
Method and device for controlling an electric apparatus by means of a pulse width modulation device
Méthode et dispositif pour le réglage d'un appareil électrique par l'utilisation d'un dispositif de modulation de largeur d'impulsions

(30) Priorität: 30.11.1993 DE 4340769
(43) Veröffentlichungstag der Anmeldung: 31.05.1995
(73) Patentinhaber: ROBERT BOSCH GMBH, 70442 Stuttgart (DE)
(72) Erfinder: Peter, Cornelius, Dipl.-Ing., D-77815 Bühl (DE); Bertolini, Thomas, Dr.-Ing., D-77866 Rheinau (DE); Moench, Wolfgang, D-76530 Baden-Baden (DE)

(56) Entgegenhaltungen:
- EP-A- 0 338 798
- WO-A-90/12446
- US-A- 5 162 709
- US-A- 5 210 474

## Beschreibung

### STAND DER TECHNIK

Die Erfindung betrifft ein Verfahren zur Steuerung elektrischer Geräte mittels einer Pulsweitenmodulations-Einrichtung, wobei das Ein- und Ausschalten des elektrischen Geräts mit niedriger Taktfrequenz im Bereich 20 Hz bis 10 kHz erfolgt, sowie eine Vorrichtung zur Durchführung des Verfahrens.

Ein derartiges Pulsweiten-Modulationsverfahren dient dazu, um den Strom in einem elektrischen Gerät, insbesondere in einem Elektromotor, in seiner Höhe zu variieren. Dabei wird die Betriebsspannung mittels eines Halbleiterschalters zyklisch ein- und ausgeschaltet. Häufig erfolgt das Ein- und Ausschalten mit einer oberhalb der Hörfrequenzgrenze liegenden Frequenz, um störende Geräusche zu vermeiden. Dies führt jedoch zu hohen Umschaltverlusten im Halbleiterschalter, der wegen der damit verbundenen Bauteil erwärmung einen großen Kühlkörper benötigt. Weiterhin ist bei der hochfrequenten Taktung ein großer Kondensator zum Schutz des Transistors bzw. zur Zwischenspeicherung der durch die Taktung auftretenden Ströme erforderlich. Solche Kondensatoren liegen im Bereich zwischen 100 und 2000 µF. Ein weiterer Nachteil besteht darin, daß ein Steuerrechner mit der Erzeugung der hochfrequenten Taktsignale völlig ausgelastet wäre und praktisch keine zusätzlichen Funktionen mehr erfüllen könnte. Aus diesem Grunde wird häufig eine zusätzliche Hardware-Schaltung zur Erzeugung der Taktfrequenz vorgesehen.

Eine weitere bekannte Möglichkeit besteht darin, bei der Pulsweitenmodulation eine niederfrequente Taktung einzusetzen, beispielsweise im Bereich von 200 Hz. Die Vorteile bestehen insbesondere darin, daß kein zusätzlicher Hardware-Aufwand zur Erzeugung der Taktfrequenz erforderlich ist und der große Kondensator entfallen kann, beziehungsweise durch einen Entstörkondensator mit wesentlich niedrigerer Kapazität ersetzt werden kann. Weiterhin ist die durch Schaltverluste der Halbleiterschalter entstehende Verlustleistung gering, so daß kleine Kühlflächen ausreichend sind. Auch die elektromagnetische Verträglichkeit (EMV) ist gegenüber der hochfrequenten Taktung deutlich verbessert, das heißt, der EMV-Störpegel stellt hier praktisch kein Problem dar. Allerdings müssen diese Vorteile durch eine deutliche Geräuschentwicklung durch Luft- und Körperschall erkauft werden. Auch kann ein ungleichmäßiger Motorlauf bei kleinem Tastverhältnis auftreten. Dies kann zu einer Standzeit-Reduzierung führen, je nach Taktfrequenz bis zu 40 %.

Aus der US-PS 5162709 ist die Steuerung eines elektronisch komutierten Lüftermotors mit Hilfe einer niederfrequenten Pulsweitenmodulations-Einrichtung beschrieben. Dort wird durch variable Ansteuerimpulsformen versucht, eine Geräuschreduzierung zu erreichen. Dies gelingt jedoch trotz erheblichen Steueraufwandes nur beschränkt.

### VORTEILE DER ERFINDUNG

Das erfindungsgemäße Verfahren und die erfindungsgemäße Vorrichtung mit den kennzeichnenden Merkmalen der Ansprüche 1 und 7 haben demgegenüber den Vorteil, daß die Vorteile der niederfrequenten und der hochfrequenten Pulsweitenmodulationstaktung unter Vermeidung der Nachteile kombiniert werden. Dies bedeutet insbesondere, daß keine niederfrequenten Geräusche, wie Pfeifen und Klirren, auftreten und dennoch eine Reduzierung des Hardware-Aufwandes, eine Verminderung des Störpegels und eine Reduzierung der Schaltverluste bei kleiner ausgelegten Kühlflächen der Endstufen erreicht werden können. Die bei der niederfrequenten Taktung reduzierte Standzeit wird erhöht und ein unregelmäßiger Motorlauf verhindert.

Durch die in den Unteransprüchen aufgeführten Maßnahmen sind vorteilhafte Weiterbildungen und Verbesserungen des im Anspruch 1 angegebenen Verfahrens und der im Anspruch 7 angegebenen Vorrichtung möglich.

Die hochfrequenten Taktsignale am Ende eines niederfrequenten Taktsignals weisen vorzugsweise ein einen zeitlich sinusförmig verlaufenden Stromabfall erzeugendes Tastverhältnis auf, um Geräusche nahezu vollständig zu verhindern oder ein rauschartiges Geräusch zu erzeugen, welches im stets vorhandenden Lagergeräusch untergeht.

Es werden vorzugsweise niederfrequente Taktfrequenzen von weniger als 600 Hz eingesetzt, wobei sich eine Taktfrequenz von im wesentlichen 200 Hz als besonders geeignet erwiesen hat.

Zur Realisierung des im wesentlichen sinusförmigen Verlaufs der fallenden Stromflanke werden vorzugsweise Stromstützwerte errechnet, aus denen dann das jeweilige Tastverhältnis der hochfrequenten Taktsignale bestimmt wird. Insbesondere wird jeweils der Ein- und der Ausschaltzeitpunkt errechnet und dadurch eine Steuersignalfolge vorgegeben.

Ein parallel zum elektrischen Gerät geschalteter Kondensator ermöglicht eine Erhöhung der Zeitkonstante des Motor-/Endstufensystems, die dadurch auf einen Wert gesetzt wird, der mit relativ einfachen Mitteln zu realisieren ist.

Gleichzeitig wirkt dieser Kondensator als Puffer, so daß die Störabstrahlung erheblich reduziert wird. Ein geeigneter Kapazitätswert ist beispielsweise ein Wert von 1,0 µF.

Die Halbleiterschalter sind zweckmäßigerweise als FET-Transistoren ausgebildet, wobei als Steuereinheit vorzugsweise ein Mikrorechner verwendet wird. Das erfindungsgemäße Verfahren und die entsprechende Vorrichtung eignen sich vor allem für die Steuerung eines Elektromotors.

### ZEICHNUNG

Zwei Ausführungsbeispiele der Erfindung sind in der Zeichnung dargestellt und in der nachfolgenden Beschreibung näher erläutert. Es zeigen:
- Fig. 1: ein erstes Ausführungsbeispiel mit einem in Reihe zu einem Elektromotor geschalteten Steuertransistor,
- Fig. 2: ein zweites Ausführungsbeispiel mit vier Steuertransistoren in einer Brückenschaltung,
- Fig. 3: ein Signaldiagramm zur Erläuterung der Wirkungsweise und
- Fig. 4: eine vergrößerte Darstellung des durch hochfrequente Taktung erreichten Sinusabfalls nach dem niederfrequenten Taktsignal.

### BESCHREIBUNG DER AUSFüHRUNGSBEISPIELE

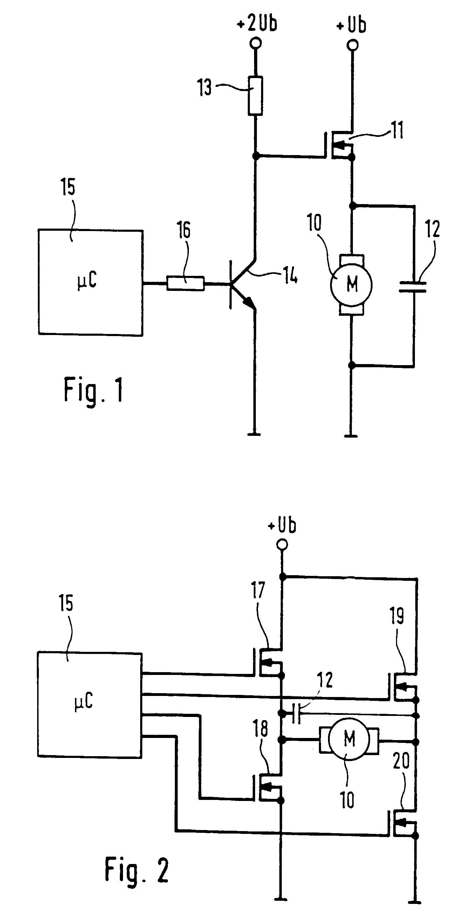

Bei dem in Fig. 1 dargestellten ersten Ausführungsbeispiel ist ein Elektromotor 10 in Reihe mit einem Feldeffekt-Steuertransistor 11 (FET 11) an eine Versorgungsspannung Ub gelegt. Parallel zum Elektromotor 10 liegt ein Kondensator 12. Der GATE-Anschluß des FET 11 ist mit dem Verknüpfungspunkt eines Widerstands 13 mit einem Transistor 14 verbunden. Die Reihenschaltung des Widerstands 13 mit der Schaltstrecke des Transistors 14 liegt an der doppelten Versorgungsspannung 2 Ub. Ein Steuerausgang einer als Mikrorechner 15 ausgebildeten Steuereinheit steuert die Basis des Transistors 14.

Eine Taktsignalfolge als Pulsweitenmodulations-Signal (PWM-Signal) wird im Mikrorechner 15 erzeugt und taktet über den Widerstand 16 entsprechend den Transistor 14. über die Pulsweite wird das Drehmoment und damit indirekt auch die Leistung des Elektromotors 10 eingestellt. Da zur Durchsteuerung des FET 10 der GATE-Anschluß ein positiveres Potential gegenüber dem SOURCE-Anschluß aufweisen muß, wird über den Widerstand 13 die Hilfsspannung 2 Ub angelegt. Bei einer Taktfrequenz im Bereich zwischen 50 Hz und 10 kHz spricht man von niederfrequenter und im Bereich zwischen 10 kHz und 100 kHz von hochfrequenter Taktung. Problematisch bei der niederfrequenten Taktung sind unter anderem die dabei auftretenden, als lästig empfundenen Geräusche (Luft- und Körperschall), da diese Taktfrequenz im Hörbereich des menschlichen Ohrs liegt und den Motor zu Schwingungen anregt. Bei einer Taktfrequenz in einem für das menschliche Ohr nicht mehr wahrnehmbaren Frequenzbereich ab 20 kHz treten diese Geräusche nicht mehr auf, dort ist aber mit einer Störung bei Tieren zu rechnen.

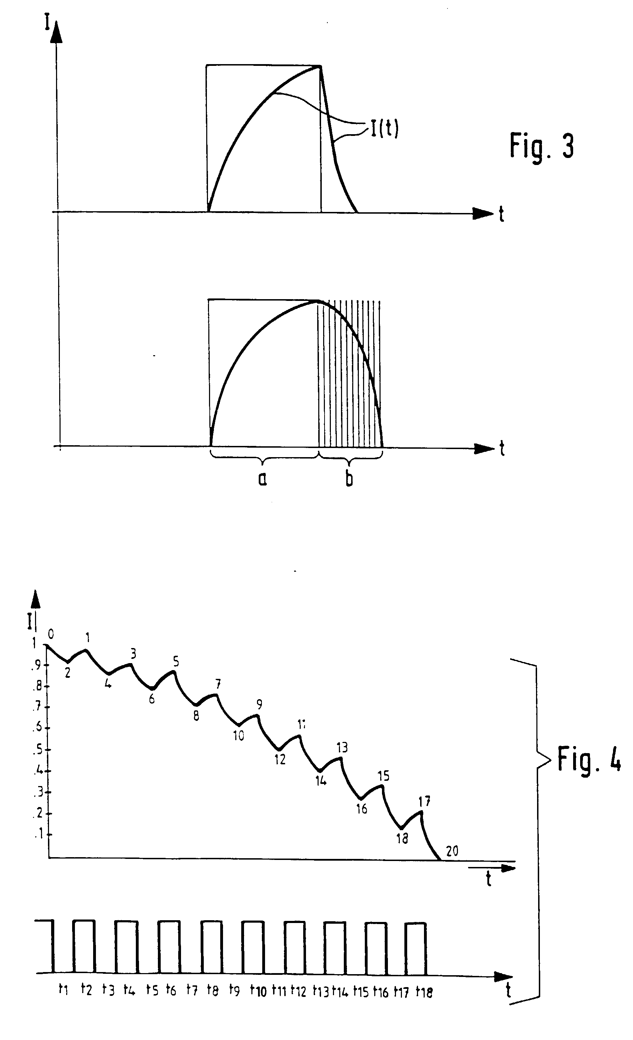

Im oberen Bereich von Fig. 3 ist ein rechteckiges niederfrequentes Taktsignal dargestellt, das zu einem Stromfluß I (t) führt, der nach einer (1-e)-Funktion ansteigt und nach Beendigung des Taktsignals wieder nach einer (1/e)-Funktion abfällt. Analysiert man das Spektrum dieses Stromverlaufs, so stellt man fest, daß sich das Spektrum aus einer Grundschwingung (Taktfrequenz) und höherfrequenten spektralen Anteilen (Oberwellen) zusammensetzt. Die Grundschwingung emittiert Körperschall und die Oberwellen Luftschall. Körperschall entsteht, wenn der Anker durch die Grundschwingung zu Pendelbewegungen angeregt wird. Die bei der Taktung auftretenden höherfrequenten spektralen Anteile des Stromverlaufs regen bei entsprechender Amplitude mechanische Elemente des Motors zu Schwingungen an. Betroffen hiervon sind vor allem mechanische Verbindungsstellen, z. B. die mit Federn am Polrohr befestigten Magnete, Lager u.dgl. Analysiert man das Spektrum der Luftschallmessung eines mit einer Frequenz von 600 Hz getakteten Motors, so kann man im Bereich von 4 kHz ein Pegel-Maximum erkennen. In diesem Frequenzbereich liegt aber auch die größte Empfindlichkeit des menschlichen Ohres, so daß der emittierte Luftschall subjektiv als sehr lästig empfunden wird. Um den Luftschall bei niederfrequenter Taktung zu reduzieren, ist ein zeitlich möglichst glatter, z. B. sinusförmiger Stromverlauf durch den Anker anzustreben. Durch die Anwendung des hochfrequenten PWM-Taktverfahrens bei ca. 20 kHz ist eine Annäherung an den idealen Stromverlauf möglich. Dies ist im unteren Bereich von Fig. 3 dargestellt. Der Mikrorechner 15 erzeugt eine Grundtaktsignalfolge von niederfrequenten Taktsignalen a, wobei jedem Taktsignal a eine Folge von hochfrequenten Taktsignalen b folgt. Die Impulsbreite der hochfrequenten Taktsignale wird dabei im Bereich der abfallenden Flanke des niederfrequenten Signals so variiert, daß ein nahezu sinusförmiger Stromverlauf moduliert wird. Die Zeitkonstante, die sich aus R, L und C des Systems Endstufe (FET 11)/Elektromotor 10 ergibt, bestimmt die Taktfrequenz. Die Impulsweiten variieren beispielsweise zwischen 1,6 ps und 180 ps. Entscheidend ist jedoch, daß nur zeitweise hochfrequent getaktet werden muß, nämlich im Bereich der abfallenden Flanke des niederfrequenten Signals. Dies bedeutet in der Praxis, daß der zur Motorsteuerung eingesetzte Mikrorechner 15, der auch die Signale für die Pulsweitenmodulation generiert, für diese Aufgabe nur zeitlich begrenzt blockiert wird.

Der Kondensator 12 erhöht die Zeitkonstante des Motor-/ Endstufen-Systems. Ohne den Kondensator wird beispielsweise eine Zeitkonstante von 60 ps erreicht. Rechnerisch ergäbe sich daher als kleinster Wert eine Pulsweite von 685 ns, in der Praxis ein Wert, der mit vorhandenen Mitteln nicht zu realisieren ist. Die Verwendung des Kondensators 12 führt zu realisierbaren Pulsweiten. Dieser Kondensator 12 wirkt auch als Puffer, durch den die Störabstrahlung erheblich reduziert wird. Bei der Dimensionierung des Kondensators 12 ist zu berücksichtigen, daß dieser ein Bestandteile für die Grundentstörung des Motors ist. Unter dieser Voraussetzung kann beispielsweise für die Kapazität des Kondensators 12 ein Wert von 1 µF festgelegt werden.

Die Vorgehensweise für die Festlegung der hochfrequenten Taktsignalfolge am Ende jedes niederfrequenten Taktsignals ist die folgende. Zunächst wird die optimale Taktfrequenz ermittelt. Dann wird die Anzahl der Stützpunkte bestimmt, wie dies aus Fig. 4 hervorgeht. Um einen sinusförmigen Flankenabfall zu erreichen, müssen die Einschalt- und Ausschaltzeitpunkte für die hochfrequente Taktsignalfolge bestimmt werden. Im in Fig. 4 dargestellten Beispiel sind es 21 Stützpunkte (entsprechend 9 Taktsignalen). Diese Stützpunkte müssen für den gewünschten sinusförmigen Stromverlauf berechnet werden. Dann muß die Zeitkonstante für das System Motor/Endstufe bestimmt werden, und schließlich werden die Pulsweiten für die Flankentaktung gemäß Fig. 4 berechnet.

Zur Ermittlung der optimalen Taktfrequenz müssen Körperschallmessungen am Motor vorgenommen werden. Für die niederfrequente Taktung kommt ein Frequenzbereich von 20 bis 400 Hz in Frage. Es muß geprüft werden, ob die durch das Takten auftretenden Pendelbewegungen des Ankers zu Resonanzeffekten im Bereich des Körper- und Luftschalls führen. Dazu wird der Motor mit einer sinusförmigen Wechselspannung im Bereich von 20 bis 600 Hz angeregt und Körper-Luftschallmessungen durchgeführt. Versuche haben ergeben, daß beispielsweise für einen im Handel erhältlichen Motor AHP 0390201685 die günstigste Taktfrequenz bei etwa 200 Hz liegt. Dieser günstigste Bereich hängt selbstverständlich vom konstruktiven Aufbau des Motors ab.

Bei der Anzahl der Stützpunkte für die Strommodulation muß ein Kompromiß gefunden werden. Die Anzahl der Stützpunkte bestimmt die Welligkeit des Stromverlaufs. Wird eine zu geringe Anzahl von Stützpunkten eingesetzt, können die dadurch entstehenden Oberwellen mechanische Teile des Motors zu Schwingungen anregen und damit zu einer Geräuschentwicklung führen. Die gemäß Fig. 4 festgelegte Anzahl von 21 Stützpunkten stellt einen guten Kompromiß zwischen Welligkeit und Aufwand dar.

Die mathematische Berechnung der Zeitkonstanten des Systems Motor/Endstufe ist sehr komplex, jedoch ist die meßtechnische Ermittlung ausreichend. Hierzu wird die Zeitdauer für die abfallende Flanke des Stromverlaufs gemessen.

Durch die nur kurzzeitige hochfrequente Taktung entsteht eine wesentlich geringere Wärmeentwicklung beim FET 11, so daß sich erheblich verringerte Kühlflächen gegenüber einer vollständigen hochfrequenten Taktung ergeben.

Beim zweiten, in Fig. 2 dargestellten Ausführungsbeispiel ist der Elektromotor 10 in eine aus vier FET 17 - 20 bestehende Brückenschaltung geschaltet, die zwischen der Versorgungsspannungsklemme mit dem positiven Potential Ub und Masse liegt. Der Kondensator 12 liegt wieder parallel zum Elektromotor 10.

Zur Steuerung des Motors 10 in den beiden Drehrichtungen wird jeweils alternativ der aus den FET 17 und 20 bestehende Brückenzweig oder der aus den FET 18 und 19 bestehende Brückenzweig stromleitend geschaltet, das heißt, in der beschriebenen Weise getaktet. Dabei kann selbstverständlich jeweils ein Transistor des Brückenzweigs ständig stromleitend geschaltet sein.

## Patentansprüche

1. Verfahren zur Steuerung elektrischer Geräte mittels einer Pulsweitenmodulations-Einrichtung, wobei das Ein- und Ausschalten des elektrischen Geräts mit niedriger Taktfrequenz im Bereich zwischen 20 Hz bis 10 kHz erfolgt, dadurch gekennzeichnet, daß sich jedem niederfrequenten Taktsignal (a) mehrere, den Stromabfall verzögernde hochfrequente Taktsignale (b) gleicher oder unterschiedlicher Frequenz im Bereich 1 kHz bis 100 kHz anschließen.

2. Verfahren nach Anspruch 1, dadurch gekennzeichnet, daß die hochfrequenten Taktsignale jeweils ein den sinusartigen Stromabfall des niederfrequenten Taktsignals erzeugendes Tastverhältnis aufweisen.

3. Verfahren nach Anspruch 1 oder 2, dadurch gekennzeichnet, daß die niederfrequente Taktfrequenz weniger als 600 Hz, insbesondere im wesentlichen 200 Hz, beträgt.

4. Verfahren nach einem der vorhergehenden Ansprüche, dadurch gekennzeichnet, daß Stromstützwerte zur Realisierung des im wesentlichen sinusartigen Stromabfalls errechnet und daraus das jeweilige Tastverhältnis der hochfrequenten Taktsignale bestimmt wird.

5. Verfahren nach Anspruch 4, dadurch gekennzeichnet, daß für die hochfrequenten Taktsignale jeweils der Ein- und der Ausschaltzeitpunkt errechnet und dadurch eine Steuersignalfolge vorgegeben wird.

6. Verfahren nach einem der vorhergehenden Ansprüche, dadurch gekennzeichnet, daß das elektrische Gerät (10) mit einer Pufferkapazität beschaltet wird.

7. Vorrichtung zur Durchführung des Verfahrens nach einem der vorhergehenden Ansprüche, dadurch gekennzeichnet, daß das zu steuernde elektrische Gerät (10) in Reihe mit wenigstens einem von einer Steuereinheit (15) gesteuerten Halbleiterschalter (11; 17-20) geschaltet ist, wobei die Steuereinheit (15) Mittel zur Erzeugung einer niedrigen Taktfrequenz sowie einer hohen Taktfrequenz aufweist, wobei jedem niederfrequenten Taktsignal mehrere hochfrequente Taktsignale folgen.

8. Vorrichtung nach Anspruch 7, dadurch gekennzeichnet, daß ein Kondensator (12; 21) parallel zum elektrischen Gerät (10) geschaltet ist.

9. Vorrichtung nach Anspruch 7 oder 8, dadurch gekennzeichnet, daß vier Halbleiterschalter (17-20) in einer Brückenschaltung angeordnet sind.

10. Vorrichtung nach einem der Ansprüche 7 bis 9, dadurch gekennzeichnet, daß die Halbleiterschalter (11; 17-20) als FET-Transistoren ausgebildet sind.

11. Vorrichtung nach einem der Ansprüche 7 bis 10, dadurch gekennzeichnet, daß die Steuereinheit (15) als Mikrorechner ausgebildet ist.

12. Vorrichtung nach einem der Ansprüche 7 bis 11, dadurch gekennzeichnet, daß das elektrische Gerät (10) ein Elektromotor ist.

## Claims

1. Method for controlling electrical devices by means of a pulse width modulation device, the electrical device being switched on and off at a low clock frequency in the range between 20 Hz to 10 kHz characterized in that each low-frequency clock signal (a) is followed by a plurality of high-frequency clock signals (b) which delay the current decrease and are at the same or a different frequency in the range from 1 kHz to 100 kHz.

2. Method according to Claim 1, characterized in that the high-frequency clock signals each have a duty ratio that produces the sinusoid-like current decrease of the low-frequency clock signal.

3. Method according to Claim 1 or 2, characterized in that the low-frequency clock frequency is le-ss than 600 Hz, in particular essentially 200 Hz.

4. Method according to one of the preceding claims, characterized in that discrete current values for realizing the essentially sinusoid-like current decrease are calculated and the respective duty ratio of the high-frequency clock signals is determined therefrom.

5. Method according to Claim 4, characterized in that the switch-on and switch-off instance are in each case calculated for the high-frequency clock signals and, as a result, a control signal train is predetermined.

6. Method according to one of the preceding claims, characterized in that the electrical device (10) is connected up to a buffer capacitor.

7. Apparatus for carrying out the method according to one of the preceding claims, characterized in that the electrical device (10) to be controlled is connected in series with at least one semiconductor switch (11;17--20) controlled by a control unit (15), the control unit (15) having means for generating a low clock frequency as well as a high clock frequency, each low-frequency clock signal being followed by a plurality of high-frequency clock signals.

8. Apparatus according to Claim 7, characterized in that a capacitor (12; 21) is connected in parallel with the electrical device (10).

9. Apparatus according to Claim 7 or 8 characterized in that four semi conductor switches (17-20) are arranged in a bridge circuit.

10. Apparatus according to one of Claims 7 to 9 characterized in that the semi conductor switches (11;17-20) are designed as FET transistors.

11. Apparatus according to one of Claims 7 to 10, characterized in that the control unit (15) is designed as a microcomputer.

12. Apparatus according to one of Claims 7 to 11, characterized in that the electrical device (10) is an electric motor.

## Revendications

1. Procédé de commande d'appareils électriques par une installation à modulation de durée d'impulsion, le branchement et la coupure de l'appareil électrique se faisant à une fréquence d'horloge dans une plage comprise entre 20 Hz et 10 kHz,
caractérisé en ce que
chaque signal d'horloge (a) basse fréquence, est muni chaque fois de plusieurs signaux d'horloge (b) haute fréquence, retardant la chute du courant, ces signaux d'horloge ayant une fréquence identique ou différente dans la plage comprise entre 1 kHz et 100 kHz.

2. Procédé selon la revendication 1,
caractérisé en ce que
les signaux d'horloge haute fréquence ont chaque fois un rapport de travail générant la chute d'intensité sinusoïdale du signal d'horloge basse fréquence.

3. Procédé selon la revendication 1 ou 2,
caractérisé en ce que
la fréquence d'horloge basse fréquence est inférieure à 600 Hz et notamment très inférieure à 200 Hz.

4. Procédé selon l'une quelconque des revendications précédentes,
caractérisé en ce qu'
on calcule des valeurs d'appui d'intensité pour réaliser la chute de courant essentiellement sinusoïdale, et on en déduit le rapport de détection respectif du signal d'horloge haute fréquence.

5. Procédé selon la revendication 4,
caractérisé en ce que
pour les signaux d'horloge haute fréquence, on calcule chaque fois le point de branchement et le point de coupure et, à partir de là, on prédétermine une suite de signaux de commande.

6. Procédé selon l'une quelconque des revendications précédentes,
caractérisé en ce que
l'appareil électrique (10) est relié à une capacité tampon.

7. Dispositif pour la mise en oeuvre du procédé selon l'une des revendications précédentes,
caractérisé en ce que
• l'appareil (10) à commande électrique est branché en série avec au moins un commutateur à semi-conducteur (11 ; 17, 20) commandé par une unité de commande (15),
• une unité de commande (15) comporte des moyens pour générer une fréquence d'horloge faible ainsi qu'une fréquence d'horloge élevée, et chaque signal d'horloge basse fréquence est suivi par plusieurs signaux d'horloge haute fréquence.

8. Dispositif selon la revendication 7,
caractérisé en ce qu'
un condensateur (12, 21) est branché en parallèle sur l'appareil (10).

9. Dispositif selon les revendications 7 ou 8,
caractérisé par
quatre interrupteurs semi-conducteurs (17, 18) montés dans un montage en pont.

10. Dispositif selon l'une quelconque des revendications 7 à 9,
caractérisé en ce que
les interrupteurs à semi-conducteurs (11 ; 17 - 20) sont des transistors à effet de champ.

11. Dispositif selon l'une des revendications 7 à 10,
caractérisé en ce que
l'unité de commande (15) est un microcalculateur.

12. Dispositif selon l'une des revendications 7 à 11,
caractérisé en ce que
l'appareil électrique (10) est un moteur électrique.
